# EUROPEAN PATENT APPLICATION

(11) **EP 4 546 426 A1**
(43) Date of publication of application: **30.04.2025**
(21) Application number: 23205504.6
(22) Date of filing: 24.10.2023
(51) Int. Cl.: H01L 27/146, H04N 25/131

(54) **AN IMAGING DEVICE AND A METHOD FOR IMAGING**

(71) Applicant: Imec VZW, 3001 Leuven (BE)
(72) Inventor: Kim, Joo Hyoung, 3000 Leuven (BE); De Munck, Koen, 3210 Linden (BE); Genoe, Jan, 3272 Testelt (BE)
(74) Representative: AWA Sweden AB

(57) **Abstract**

An imaging device (100) comprises: a semiconductor substrate (102); and an array (110) of light detecting units (112a-d), wherein the array (110) comprises light detecting units (112a-c) of a first type for detecting light in a first wavelength range, each comprising a photo-sensitive area (120) formed in or at a main surface (104) of the semiconductor substrate (102), wherein the array (110) further comprises light detecting units (112d) of a second type for detecting light in a second wavelength range, each comprising a stacked layer structure (130) formed on the main surface (104), wherein the light detecting units of the first and the second types are configured to detect spatially separate light; wherein the imaging device (100) further comprises read-out electronics (150) for simultaneous read out of signals representative of light incident on the light detecting units (112a-d) of the first type and the second type.

## Description

### Technical field

The present description relates to an imaging device and a method for imaging. In particular, the present description relates to imaging that is suited for sensing a broad range of wavelengths.

### Background

Using silicon in light detection sets limits to the wavelengths that may be detected, based on optical characteristics of silicon. Therefore, it is of interest to use other materials in light detection. In this regard, light detecting units that may be formed using thin-film technology is interesting, since such light detecting units could be monolithically integrated on semiconductor substrates to still make use of the semiconductor substrate to provide circuitry for read-out and processing of signals from the light detecting units.

In particular, a combination of light detection based on different types of light detecting units may allow imaging in a broad range of wavelengths. This may allow for acquiring extensive information in an image of a scene. However, there is a need for improvements in combining different types of light detecting units in a compact imaging device and for providing fast imaging of a scene in a broad range of wavelengths.

### Summary

An objective of the present description is to enable imaging of a broad range of wavelengths, wherein imaging is enabled using a compact imaging device and wherein imaging of the broad range of wavelengths can be provided at a high imaging rate.

This and other objectives are at least partly met by the invention as defined in the independent claims. Preferred embodiments are set out in the dependent claims.

According to a first aspect, there is provided an imaging device comprising: a semiconductor substrate; and an array of light detecting units for sensing light incident on the light detecting units, wherein the array comprises light detecting units of a first type for detecting light in a first wavelength range, wherein each light detecting unit of the first type comprises a photo-sensitive area of a first type formed in or at a main surface of the semiconductor substrate, wherein the array further comprises light detecting units of a second type for detecting light in a second wavelength range different from the first wavelength range, wherein each light detecting unit of the second type comprises a stacked layer structure formed on the main surface of the semiconductor substrate, wherein the stacked layer structure comprises an active layer, which forms a photo-sensitive area of a second type and is configured to generate charges in response to incident light, wherein the stacked layer structure is configured to control transporting of charges generated by the active layer; wherein the light detecting units of the first type and light detecting units of the second type are arranged displaced in relation to each other in a direction along the main surface of the semiconductor substrate such that the photo-sensitive areas of the first type are configured to detect light that is spatially separate from light detected by the photo-sensitive areas of the second type; wherein the imaging device further comprises read-out electronics for read out of signals representative of light incident on the light detecting units, wherein a first portion of the read-out electronics associated with the light detecting units of the first type and a second portion of the read-out electronics associated with the light detecting units of the second type are configured to receive control signals with a common timing such that signals from the light detecting units of the first type and the light detecting units of the second type are read out simultaneously.

Thus, the imaging device comprises light detecting units of a first type and a second type. The light detecting units of the different types may be adapted to detect light of different wavelength ranges such that the combination of the light detecting units of the first and second types allows the imaging device to detect a broad range of wavelengths. It should be further realized that the imaging device may further comprise additional light detecting units allowing the imaging device to detect light of even further wavelength ranges.

The first wavelength range detected by the light detecting units of the first type may be tied to a material used in the semiconductor substrate. Typically, the semiconductor substrate may be formed by silicon, such that the first wavelength range is defined by sensitivity of silicon. Hence, the first wavelength range may comprise visible light and near-infrared light.

A material used for light detection in the light detecting units of the second type may be more freely selected, thanks to the light detecting units of the second type comprising a stacked layer structure allowing the materials to be selected and not necessarily be tied to the material of the semiconductor substrate. Thus, the material may be selected based on a wavelength range of interest, such that the second wavelength range encompasses wavelengths of interest to be detected.

It should be realized that the first wavelength range and the second wavelength range may overlap. Thus, the second wavelength range being different from the first wavelength range does not necessarily imply that the wavelength ranges are disjoint. Rather, the first and second wavelength ranges may preferably have an overlap such that a continuous range of wavelengths may be detected by the imaging device. The first wavelength range may comprise wavelength bands that are not part of the second wavelength range and the second wavelength range may comprise wavelength bands that are not part of the first wavelength range. Thus, the first wavelength range and the second wavelength range may be combined to extend an overall wavelength range of the imaging device compared to individual wavelength ranges of the light detecting units of the first type and the second type, respectively. It should also be realized that, even if the photo-sensitive areas of the first type may be sensitive to wavelengths in the second wavelength range, sensitivity of the photo-sensitive areas of the second type may be better in the second wavelength range compared to the sensitivity of the photo-sensitive areas of the first type, and vice versa. Thus, the light detecting units of different types may be used for providing a high sensitivity to incident light in a broad range of wavelengths.

It should further be realized that the light detecting units in the array may be configured to detect light in a plurality of wavelength bands within the first and/or second wavelength ranges. For instance, the photo-sensitive area of the first type may be sensitive to light in the first wavelength range. However, the imaging device may further be configured to control wavelengths of light that are incident on a photo-sensitive area of a specific light detecting unit, and different photo-sensitive areas of different specific light detecting units may be configured to receive different wavelengths of light within the first wavelength range. In this manner, the array of light detecting units may be configured to provide spectral imaging, wherein light is detected in a plurality of wavelength bands within the first wavelength range and the second wavelength range.

According to an embodiment, the light detecting units of the first type may be used for detecting visible light using photo-sensitive areas formed in a silicon substrate. The light detecting units of the second type may be used for detecting light in a second wavelength range complementing light detected by the light detecting units of the first type. Thus, the light detecting units of the second type may for instance be configured to detect infrared light or ultraviolet light or light of another wavelength range differing from the first wavelength range.

Thanks to providing the light detecting units of the first type and the light detecting units of the second type on a common semiconductor substrate, the imaging device may be very compact. In addition, the light detecting units of the different types may be arranged very close to each other, such that the light detecting units may be arranged to image a common object or a common scene. The light detecting units of different types may be alternatingly arranged within the array such that the light detecting units may be configured to image the common object or the common scene with a spectral resolution in the combined first and second wavelength ranges.

For instance, a combination of visible and infrared imaging may be particularly useful in imaging of a scene at nighttime, such as imaging of a scene around a car during nighttime for presenting augmented information to a driver.

The use of light detecting units of different types for acquiring information of different wavelengths implies that imaging and read-out of light detecting units of different types need to be controlled in the same imaging device. The imaging device is configured to provide control signals with a common timing for simultaneously reading out signals from the light detecting units of the first and second types. This implies that the information relating to the first wavelength band and information relating to the second wavelength band may be read out simultaneously and that the imaging device need not capture different frames for the different wavelength bands. Thus, the imaging device may use a high imaging rate since there is no need to acquire different frames for different wavelength bands. In addition, simultaneous acquisition of wavelengths from an imaged object or scene implies that the object or scene does not change between frames dedicated to different wavelengths. Thus, the spectral information may be acquired without a risk of motion blur between different wavelength bands. Hence, the image device may be configured to acquire high quality images with a spectral resolution.

The simultaneous read-out of the light detecting units of the first and second types implies that a frame including information from all light detecting units within the array may be read out at one time. The control signals having a common timing may be configured to control a start time and an end time of an integration period to be the same for the light detecting units of the first and the second types. However, it should be realized that, in some embodiments, a control signal scheme for the light detecting units of the first type may not have exactly the same timing as a control signal scheme for the light detecting units of the first type. For instance, a start time for starting integration may differ slightly. This may be used if light intensity is different for different wavelengths, such that a longer integration period may be needed for some wavelengths.

According to an embodiment, the first portion of the read-out electronics and the second portion of the read-out electronics may receive identical control signals. This implies that the control signal scheme may be the same for controlling acquisition of image information by the light detecting units of the first and second types. In such case, the imaging device may be provided with control lines for transmitting control signals to the first and second portions of the read-out electronics, wherein at least some of the control lines are shared by the first portion and the second portion of the read-out electronics. This may facilitate arrangement of the light detecting units of different types in an alternating manner, such as in a mosaic configuration, wherein a pattern of arranging the light detecting units is repeated across the array.

However, it should be realized that the first and second portions of the read-out electronics may be associated with different control lines. In such case, there is a higher degree of freedom of control signals, allowing different control signals to be provided, even though read out is performed simultaneously. For instance, the light detecting units of the first and second types may be arranged in alternating rows or columns of the array, which may facilitate arranging control lines such that each control line transmits control signals only to the first portion of the read-out electronics or the second portion of the read-out electronics.

Thanks to the light detecting units of different types being configured to detect spatially separate light, the imaging device may be configured to further control the light to be received by the light detecting unit of each type. This implies that the imaging device may be configured to provide one or more spectral filters, wherein each spectral filter is associated with a light detecting unit of a single type. The spectral filters may thus be configured to selectively pass light of desired wavelengths (or selectively block light of undesired wavelengths) to the light detection unit with which the spectral filter is associated. This implies that a signal-to-noise ratio for each of the respective light detecting units may be improved by providing a spectral filter that is specific to the respective light detecting units.

The light detecting units of the second type need not to be arranged immediately on the main surface of the semiconductor substrate. It should thus be realized that the light detecting units of the second type being displaced in relation to the light detecting units of the first type along the main surface of the semiconductor substrate implies that a projection of the light detecting units of the second type along a normal to the main surface of the semiconductor substrate onto the main surface is displaced in relation to the light detecting unit of the first type at the main surface. The light detecting units of different types may thus be configured to detect light that is spatially separate based on the light detecting units being displace in relation to each other.

However, it should be realized that, since the light detecting units of the second type are not arranged in a same plane as the light detecting units of the first type, there may still be a risk of crosstalk between light intended for one light detecting unit reaching a neighboring light detecting unit. Crosstalk may be avoided by using spectral filters associated with the respective light detecting units. This may ensure that light within the first range of wavelengths will be blocked in light detecting units of the second type, such that such light may not reach neighboring light detecting units of the first type to form noise therein.

Even though the photo-sensitive areas of the first type are configured to detect light that is spatially separate from light detected by the photo-sensitive areas of the second type, an origin of light may be the same such that the same object or scene is imaged by the photo-sensitive areas of the first and second types.

For instance, the imaging device may comprise an optical duplicator such that light may be split and spatially separate light may originate from same locations. This may be combined with the light detecting units of the first type being arranged in a first region of the array and the light detecting units of the second type being arranged in a second region of the array.

Alternatively, the light detecting units of the first type and the second type may be alternatingly arranged in the array such that, even though there may be a slight spatial shift between locations imaged by the light detecting units of the first type and by the light detecting units of the second type, the light detected by neighboring light detecting units of different types may be considered to originate from a common location in processing of the acquired image information.

As used herein, the term "*light*" should be broadly interpreted and is not limited to visible light. Rather, light may refer to electro-magnetic radiation in a broad spectrum, including ultraviolet light, visible light, and infrared light. Thus, the first and second wavelength ranges may be defined within a broad spectrum of wavelengths.

The semiconductor substrate may be formed by a semiconductor material. Typically, the semiconductor substrate may be formed by a wafer that is processed during manufacturing to define components in the wafer before the wafer is diced into a semiconductor substrate forming an integrated circuit for the imaging device. The photo-sensitive areas of the first type may be formed in or at a main surface of the semiconductor substrate, which may correspond to a surface of the wafer provided for manufacturing of the imaging device.

The photo-sensitive areas of the first type may for instance comprise a photodiode formed in or at the main surface of the semiconductor substrate. The photodiode may comprise a p-n junction between two regions in or at the main surface of the semiconductor substrate being differently doped, one region being positively doped by holes and one region being negatively doped by electrons. The doped regions may be formed in the surface of the semiconductor substrate, e.g., by ion implantation or diffusing of dopants. The doped regions may alternatively or additionally be formed by growing layers of crystals with different doping at the surface of the semiconductor substrate.

The photo-sensitive areas of the first type may comprise a pinned photodiode, wherein a highly positively doped region is provided on the photo-sensitive p-n junction. This may permit efficient charge transfer from the photo-sensitive area for read-out of a signal representative of incident light and also provides low noise.

It should be realized that during processing of the semiconductor substrate, further layers may be formed on the main surface of the semiconductor substrate, such as metal layers forming back-end-of-line layers providing contact to dedicated areas formed on or at the main surface of the semiconductor substrate.

It should further be realized that the stacked layer structure of the light detecting unit of the second type may be formed directly on the main surface of the semiconductor substrate. However, according to an alternative, other layers may be arranged in-between the main surface of the semiconductor substrate and the stacked layer structure.

The stacked layer structure may comprise a plurality of layers arranged on top of each other. The layers may be arranged in the stack such that each layer in the stacked layer structure is arranged to extend in parallel to the main surface of the semiconductor substrate.

The stacked layer structure may be configured to generate charges in response to incident light. The stacked layer structure may further be configured to control transport of the generated charges. For instance, the stacked layer structure may comprise a first node and a second node, wherein the stacked layer structure may be configured to accumulate charges in the first node and may be configured to control transport of charges to the second node. The stacked layer structure may be configured to control potentials within the stacked layer structure for controlling when charges are transported to the second node. It should be realized that the stacked layer structure may comprise layer(s) for providing electrical potentials for controlling the transport of charges. It should further be realized that the stacked layer structure may comprise dedicated charge transport layer(s) within which charges are transported, such that the first and second node are defined in the charge transport layer.

Thus, the stacked layer structure may for instance comprise electrode layer(s) providing control of potentials within the stacked layer structure. The electrode layers may control transport of charges within a portion of the active layer or within a charge transport layer. Thus, the first and second nodes may be defined in the active layer. It should also be realized that the first and second nodes may be defined in different layers of the stacked layer structure.

The stacked layer structure may be configured to provide a signal representative of detected light. For instance, the stacked layer structure may provide the signal representative of detected light in the second node of the stacked layer structure. The stacked layer structure may be configured to collect charges in the charge transport layer such that the signal representative of detected light may be read out from the charge transport layer. The charge transport layer may be arranged closer to the main surface of the semiconductor substrate than the active layer, such that the charge transport layer may be arranged between the active layer and the main surface of the semiconductor substrate.

The stacked layer structure may form a photodiode and may be electrically controlled to control transport of generated charges to desired layers in the stacked layer structure.

The layers of the stacked layer structure may be formed by thin-film layer deposition. Thin-film layer deposition may be suitable for monolithic integration of structures using vast amount of materials, e.g., organic materials. This may be advantageously used in the photo-sensitive device, which may be suited for use of e.g., organic materials in light detection.

Each layer may have a shape like a sheet with a large extension in two dimensions and a much smaller extension transverse to the sheet and may hence be called a thin-film layer. Thin-film layer deposition may be used for initially arranging the layers over an entire area of the array. However, the layers may then be patterned so as to define stacked layer structures in the light detecting units of the second type, whereas the stacked layer structure is not provided in the light detecting units of the first type. Thus, after patterning, the dimension of a thickness of the layers is closer to the dimension of the plane of the layers in the stacked layer structure. Nevertheless, the layers within the stacked layer structure may be referred to as thin-film layers.

The first portion of the read-out electronics may comprise a plurality of identical read-out units, wherein each read-out unit is associated with a single light detecting unit of the first type. Similarly, the second portion of the read-out electronics may comprise a plurality of identical read-out units, wherein each read-out unit is associated with a single light detecting unit of the second type. It should be realized that each read-out unit may be physically arranged in close relation to the photo-sensitive area from which a signal is to be read out. Thus, the read-out electronics may be arranged within an area occupied by the array of light detecting units. Also, the read-out units of the first portion of the read-out electronics may be alternatingly arranged in relation to the read-out units of the second portion of the read-out electronics. However, according to an alternative, signals from the photo-sensitive areas may be transmitted through signal lines away from the area occupied by the array such that at least part of the first and second portions of the read-out electronics may be arranged outside of the area occupied by the array of light detecting units. This may facilitate having a small pitch between neighboring light detecting units within the array.

According to an embodiment, the stacked layer structure of light detecting units of the second type comprises a charge transport layer comprising a first portion and a second portion, the second portion being displaced along a plane of the charge transport layer in relation to the first portion, wherein the light detecting units of the second type are configured to accumulate charges generated by the active layer in the first portion of the charge transport layer, wherein the read-out electronics for each light detecting unit of the second type comprises a transfer gate separated by a dielectric material from a transport portion of the charge transport layer between the first portion and the second portion, wherein the transfer gate is configured to control transfer of accumulated charges in the first portion to the second portion.

Thanks to the light detecting units of the second type being able to transport charges from a first portion to a second portion of the charge transport layer, a transfer gate may provide control for moving charges from the first portion to the second portion after accumulation. Thus, once the charges have been accumulated in the first portion, the charges may be transferred to the second portion, wherein a signal may be read out. This implies that signals may be read out in a controlled manner and that the light detecting units of the second type may have a low noise level.

In addition, thanks to the light detecting units of the second type being configured to use a transfer gate for moving charges to a node at which a signal may be read out, the light detecting units of the first type may also be implemented with a transfer gate for moving charges from the photo-sensitive area to a node at which a signal may be read out. Hence, both types of light detecting units may use transfer gates, allowing simultaneous read out of signals from all light detecting units of the array. This implies that the light detecting units of the first type may be implemented as a photodiode associated with a transfer gate for read-out of signals, such that the light detecting units of the first type may utilize for instance a pinned photodiode which is commonly used in imaging based on photo-sensitive areas arranged in a semiconductor substrate.

The active layer may be arranged to have an extension in the stacked layer structure corresponding to a size of the first portion of the charge transport layer. Alternatively, the active layer may extend also over the second portion of the charge transport layer. Nevertheless, the generation of charges in the active layer that are collected in the charge transport layer may be controlled so that only charges generated in the active layer above the first portion of the charge transport layer may be collected and accumulated. Thus, the photo-sensitive area of the light detecting unit of the second type may correspond to the first portion of the charge transport layer and a corresponding area in the active layer.

According to an embodiment, the second portion of the charge transport layer is connected through a via extending through layers in a direction perpendicular to the charge transport layer to a metal layer on the semiconductor substrate forming a floating diffusion node of the read-out electronics.

Thus, the light detecting units of the second type may be connected through the via to read-out electronics. This implies that read-out electronics associated with the light detecting units of the first type and with the light detecting units of the second type may be arranged in a common plane of the imaging device.

The floating diffusion node may be a node which is electrically isolated from all other nodes in the read-out electronics. The floating diffusion node may be connected to a gate of a transistor for direct amplification of a signal read out from the photo-sensitive area of the second type.

According to an embodiment, the read-out electronics comprises four transistors associated with each light detecting unit of the first type and each light detecting unit of the second type, wherein the four transistors are configured to control transfer of charges from the photo-sensitive area to a floating diffusion node, reset of the floating diffusion node, source-follower readout, and selection of read-out from the light detecting unit.

A read-out unit comprising four transistors (4T) may provide a high signal-to-noise ratio as noise levels may be low. In particular, the 4T read-out unit may have much better signal-to-noise ratio compared to a read-out unit having only three transistors and in which no transistor for transferring charges from the photo-sensitive area is used.

According to an embodiment, the read-out electronics comprises read-out integrated circuit formed in the semiconductor substrate.

This implies that the read-out electronics may be formed in the semiconductor substrate using semiconductor technology, such as using complementary metal-oxide-semiconductor (CMOS) circuitry. Thus, the imaging device may make use of existing technology for manufacturing of small-scale circuitry for forming a read-out integrated circuit of the read-out electronics.

The read-out electronics may be fully formed as read-out integrated circuit in the semiconductor substrate apart from the transfer gate for controlling transfer of charges between the first portion and the second portion of the charge transport layer of the light detecting unit of the second type.

The read-out electronics may be configured read out signals from the light detecting units. However, the read-out electronics may further be configured to process the read out signals. For instance, the read-out electronics may comprise analog-to-digital converter(s) for converting the read out signals to a digital format facilitating further processing of acquired image information.

According to an embodiment, the imaging device is configured for front-side illumination, wherein the imaging device comprises wiring layers providing electrical connection to the read-out integrated circuit, wherein the photo-sensitive areas of the first type are arranged to detect light having passed the wiring layers.

The imaging device being configured for front-side illumination may be manufactured in a straightforward manner. However, since light has to pass the wiring layers before reaching the photo-sensitive areas, some light may be blocked by the wiring layers.

The wiring layers may correspond to back-end-of-line layers of the read-out integrated circuit.

According to another embodiment, the imaging device is configured for back-side illumination, wherein the imaging device comprises wiring layers providing electrical connection to the read-out integrated circuit, wherein the photo-sensitive areas of the first type and the photo-sensitive areas of the second type are arranged on an opposite side of the read-out integrated circuit to the wiring layers.

Thus, the imaging device being configured for back-side illumination may be configured to detect light without the light passing the wiring layers. This implies that a larger proportion of light may be detected compared to front-side illumination. However, manufacturing of the device for back-side illumination may be more complicated than manufacturing of the device for front-side illumination since the semiconductor substrate need to be thinned to allow receiving light from a back side of the substrate.

The imaging device configured for back-side illumination may be advantageously used for imaging in low light conditions.

According to an embodiment, each light detecting unit of the first type comprises a color filter arranged in relation to the photo-sensitive area of the first type such that the photo-sensitive area of the first type is configured to receive incident light having passed the color filter.

Thus, the color filter may be used for selecting a wavelength band to be detected by the light detecting unit of the first type. The color filter may be configured to select a wavelength band within the first wavelength range, such that the color filter is used for selecting a particular narrow wavelength band within the broader first wavelength range to which the photo-sensitive area may be sensitive.

The imaging device may comprise a plurality of different color filters such that different light detecting units of the first type may comprise different color filters. This implies that the imaging device may be configured to selectively detect a plurality of wavelength bands within the first wavelength range. This may allow the imaging device to provide imaging with a high spectral resolution.

The color filter may be configured with material properties providing selective passing of light within a wavelength band. This may be used for providing relatively broad wavelength bands to be passed by the color filter. However, the color filter may alternatively be configured to selectively pass light within a wavelength band based on constructive interference of light, such as using a Fabry-Pérot resonator.

According to an embodiment, the imaging device further comprises a protection layer arranged on the stacked layer structure of each light detecting unit of the second type, wherein the protection layer further extends between the color filter and the photo-sensitive area of the first type.

The protection layer may provide a protection of the stacked layer structure in manufacturing steps performed after the stacked layer structure has been formed. For instance, the protection layer may provide a protection of the stacked layer structure against damage by a process for forming color filters on the light detecting units of the first type.

The protection layer may be formed at a fairly low temperature which will not harm the stacked layer structure underneath the protection layer during deposition of the protection layer. Further, the protection layer may be sufficiently inert for following patterning and etching process for forming color filters.

The protection layer may for instance be formed by a passivation layer, such as an aluminum oxide layer.

The protection layer may alternatively be patterned so as to only extend to cover the stacked layer structure of the light detecting units of the second type.

According to an embodiment, the imaging device further comprises a first wavelength filter associated with the light detecting units of the first type and arranged such that the photo-sensitive area of the first type is configured to receive incident light having passed the first wavelength filter, and a second wavelength filter associated with the light detecting units of the second type and arranged such that the photo-sensitive area of the second type is configured to receive incident light having passed the second wavelength filter, wherein the first wavelength filter is configured to block infrared light and the second wavelength filter is configured to block visible light.

The first wavelength filter may be configured to broadly pass wavelengths within the first wavelength range but may be configured to block wavelengths within the second wavelength range. Similarly, the second wavelength filter may be configured to broadly pass wavelengths within the second wavelength range but may be configured to block wavelengths within the first wavelength range. The photo-sensitive area of the first type may have a low sensitivity to light within the first wavelength range, whereas the photo-sensitive area of the second type may have a low sensitivity to light within the second wavelength range. Thus, the blocking of light by the first wavelength filter may not significantly change the light being detected by the photo-sensitive areas of the first type, and the blocking of light by the second wavelength filter may not significantly change the light being detected by the photo-sensitive areas of the second type. However, the use of the first and second wavelength filters may ensure that crosstalk of light incident onto a light detecting unit of a first type to affect detection of light by a neighboring light detecting unit of a second type may be avoided, and crosstalk of light incident onto a light detecting unit of a second type to affect detection of light by a neighboring light detecting unit of a first type may be avoided.

In particular, the light detecting units of the first type may be used for detecting visible light using photo-sensitive areas formed in a silicon substrate. Further, the light detecting units of the second type may be used for detecting infrared light. Thus, the first wavelength filter being configured to block infrared light and the second wavelength filter being configured to block visible light may be suitable for avoiding crosstalk between light detecting units of different types.

It should be realized that a wavelength filter being configured to block light does not necessarily imply that all light of a wavelength is blocked. Rather, transmission of light of the wavelength being blocked may be substantially reduced, such as at least 95% or at least 90% of the light being blocked.

According to an embodiment, the array of light detecting units comprises a plurality of image element units being repeated across the array, wherein each image element unit comprises at least one light detecting unit of the first type and at least one light detecting unit of the second type.

Thus, each image element unit may combine light detection from different types of light detecting units. The image element unit may thus be used for representing image information in a single spatial position with a spectral resolution. Since the image element units are repeated across the array, the array may be configured to acquire image information with a spatial resolution based on the number of image element units, wherein each spatial position is provided with spectral resolution.

Thanks to using at least one light detecting unit of the first type and at least one light detecting unit of the second type, the spectral resolution provided by the image element units includes information from both the first wavelength range and the second wavelength range.

According to an embodiment, each image element unit comprises a plurality of light detecting units of the first type, such as three light detecting units of the first type configured to detect red, green, and blue light, respectively and one light detecting unit of the second type configured to detect infrared light.

Thus, according to an example, three light detecting units of the first type and one light detecting unit of the second type may be used in each image element unit. However, it should be realized that other combinations of light detecting units of the first and second types may be used.

The use of the light detecting unit of the second type being configured to detect infrared light may provide an extension of conventional color imaging using red, green, and blue colors. The detection of infrared light may for instance provide valuable information in imaging at low light conditions, such as at nighttime.

The imaging device may thus be configured to combine imaging using red, green, and blue resolution, with infrared imaging of short-wave infrared light. very good for imaging in particular settings. For instance, the light detecting unit of the second type may be configured to detect light in the second wavelength range being in a range of 0.7-2.5 µm, such as in a range of 0.9-1.7 µm.

According to an embodiment, the at least one light detecting unit of the first type and the at least one light detecting unit of the second type in the image element units are arranged displaced in relation to each other in a direction along the main surface of the semiconductor substrate such that the photo-sensitive areas of the first type are configured to detect light that is spatially separate from light detected by the photo-sensitive areas of the second type.

This implies that the light detecting units of the different types may be configured to detect spatially separate light even though the light detecting units of the different types are arranged close to each other. Thus, the imaging device may be configured to further control the light to be received by the light detecting unit of each respective type, and the imaging device may also ensure that crosstalk between different light detecting units is avoided even though the light detecting units are physically close to each other.

According to an embodiment, a size of the photo-sensitive area of the second type is larger than a size of the photo-sensitive area of the first type.

For instance, the photo-sensitive areas of the second type being configured to detect infrared light may have a worse signal-to-noise ratio that photo-sensitive areas of the fist type being configured to detect visible light. Thus, having a larger size of the photo-sensitive area of the second type may be beneficial in ensuring that similar signal-to-noise ratio is provided for the light detecting units of the first and second types.

However, in order to provide corresponding spatial resolution for different wavelength bands, the size of the photo-sensitive areas may preferably not differ greatly between the light detecting units of different types.

According to a second aspect, there is provided a method for imaging comprising: detecting light of a first wavelength range using light detecting units of a first type, wherein each light detecting unit of the first type comprises a photo-sensitive area of a first type formed in or at a main surface of a semiconductor substrate; detecting light of a second wavelength range using light detecting units of a second type, wherein each light detecting unit of the second type comprises a stacked layer structure formed on the main surface of the semiconductor substrate, wherein the stacked layer structure comprises an active layer, which forms a photo-sensitive area of a second type and is configured to generate charges in response to incident light, and wherein the stacked layer structure is configured to control transporting of charges generated by the active layer, wherein the light detecting units of the first type and light detecting units of the second type are arranged displaced in relation to each other in a direction along the main surface of the semiconductor substrate such that the photo-sensitive areas of the first type are configured to detect light that is spatially separate from light detected by the photo-sensitive areas of the second type; and simultaneously reading out signals representative of light incident on the light detecting units of the first type and light incident on the light detecting units of the second type.

Effects and features of this second aspect are largely analogous to those described above in connection with the first aspect. Embodiments mentioned in relation to the second aspect are largely compatible with the first aspect.

Thus, the method provides imaging in a broad range of wavelengths the combination of the light detecting units of the first and second types allows the imaging device.

Thus, the method may use a high imaging rate since there is no need to acquire different frames for different wavelength bands within the first and second wavelength ranges. In addition, simultaneous acquisition of wavelengths from an imaged object or scene implies that the object or scene does not change between frames dedicated to different wavelengths. Thus, the spectral information may be acquired without a risk of motion blur between different wavelength bands. Hence, the method may be configured to acquire high quality images with a spectral resolution.

### Brief description of the drawings

The above, as well as additional objects, features, and advantages of the present description, will be better understood through the following illustrative and non-limiting detailed description, with reference to the appended drawings. In the drawings like reference numerals will be used for like elements unless stated otherwise.
Fig. 1 is a schematic view of an imaging device according to an embodiment.
Fig. 2 is a schematic cross-sectional view of an imaging device illustrating light detecting units of a first and a second type.
Fig. 3 is a schematic cross-sectional view of an imaging device illustrating the imaging device being configured for front-side illumination.
Fig. 4 is a schematic cross-sectional view of an imaging device illustrating the imaging device being configured for back-side illumination.
Fig. 5 is a schematic view of a layout of an image element unit according to another embodiment of the imaging device.
Fig. 6 is a schematic view of another layout of an image element unit according to yet another embodiment of the imaging device.
Fig. 7 is a flowchart of a method according to an embodiment.

### Detailed description

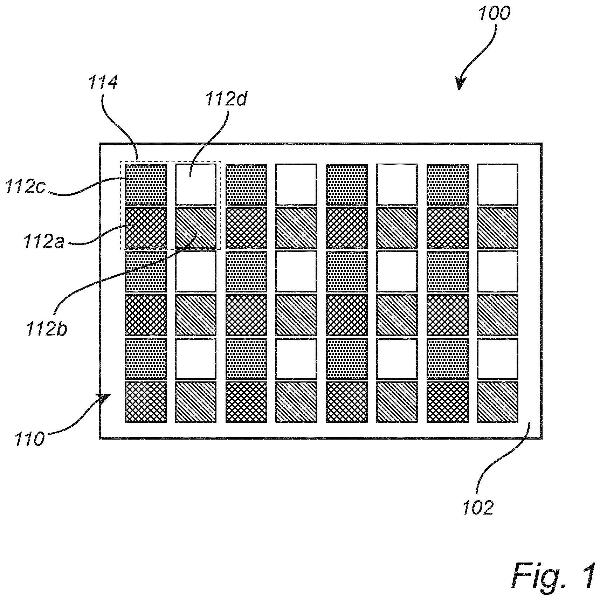

Referring now to Fig. 1, an imaging device 100 for imaging using a broad range of wavelengths will be described.

In the present description, reference is made to structures or layers defined as being arranged "above"/"on" or "below" another structure or layer. Similarly, structures are defined as being "top" or "bottom". It should be realized that such definitions do not imply that the structure or layer needs to be arranged directly on top of or directly below the other structure or layer. Rather, there may be other intermediate structures or layers in-between. It should also be realized that the structures or layers being defined in this manner are related to incident light. Thus, the embodiments of the imaging device are described as being oriented in relation to incident light to be detected by the imaging device such that a structure or layer that is closer to an origin of incident light may be referred to as being "above", "on", or "top" in relation to another structure or layer.

The imaging device 100 comprises an array 110 of light detecting units 112a, 112b, 112c, 112d. The light detecting units 112a-d are configured to sense light incident on the light detecting units 112a-d, such that an image may be formed based on image information acquired by the light detecting units 112a-d sensing incident light.

The imaging device 100 is illustrated light detecting units 112a-d comprising a plurality of image element units 114, wherein each image element unit 114 comprises a plurality of different light detecting units 112a-d. The image element unit 114 is defined as a group of light detecting units 112a-d being arranged in a specific spatial region of the array 110. Identical groups of light-detecting units 112a-d are repeated across the array 110, such that the imaging device 100 comprises image element units 114 repeated across the array 110.

The light detecting units 112a-d within an image element unit 114 are configured to detect light in different wavelength bands. Thus, the image element unit 114 is configured to sense light with a spectral resolution.

Light detecting units may have a limited wavelength range in which the light detecting units may be sensitive to light. This may for instance be due to material properties of the light detecting units. The imaging device 100 comprises light detecting units 112a, 112b, 112c of a first type and light detecting units 112d of a second type, such that the wavelength range covered by the imaging device 100 is extended beyond borders of sensitivity of a particular type of light detecting units.

Thus, the light detecting units 112a, 112b, 112c of the first type are configured to detect light in a first wavelength range, and the light detecting units 112d of the second type are configured to detect light in a second wavelength range. The first and second wavelength range may overlap or may be disjoint.

The light detecting units 112a, 112b, 112c may comprise photo-sensitive areas formed in a semiconductor substrate 102, such that the first wavelength range may be defined by material properties of the semiconductor substrate 102. For instance, if a silicon substrate is used, the light detecting units 112a, 112b, 112c may be configured to detect visible light and near infrared light extending to a wavelength of approximately 1100 nm. Spectral information that can be acquired by the light detecting units 112a, 112b, 112c may thus be extended using light detecting units 112d of a second type, which is not limited to the material properties of silicon.

The light detecting units 112d of the second type may be formed in a separate layer from the semiconductor substrate 102 and may thus not be limited to material properties of the semiconductor substrate 102. The light detecting units 112d of the second type may for instance be configured to detect infrared light, such as short-wave infrared light, which may be useful for providing complementing information to visible light information.

In the embodiment shown in Fig. 1, the image element units 114 comprise three light detecting units 112a, 112b, 112c of the first type, configured to detect red, green, and blue light, respectively, and one light detecting unit 112d of the second type, configured to detect infrared light. The repeating of the image element units 114 across the array implies that the imaging device 100 may be used for acquiring images with a spatial resolution defined by a pitch of the image element units 114 and a spectral resolution, providing red, green, blue, and infrared light information.

However, it should be realized that the light detecting units 112a, 112b, 112c of the first type may be combined with the light detecting units 112d of the second type in many different manners within the array 110. For instance, the light detecting units 112a, 112b, 112c of the first type may be arranged in a first region of the array 110 and the light detecting units 112d of the second type may be arranged in a second region of the array 110 being disjoint from the first region. According to an alternative, the light detecting units 112a, 112b, 112c of the first type may be arranged in separate rows or columns of the array 110 from the light detecting units 112d of the second type.

Thanks to the light detecting units 112a, 112b, 112c, 112d of both the first and second types being arranged on a common semiconductor substrate 102, the imaging device 100 may provide imaging based on a broad range of wavelengths in a very compact manner.

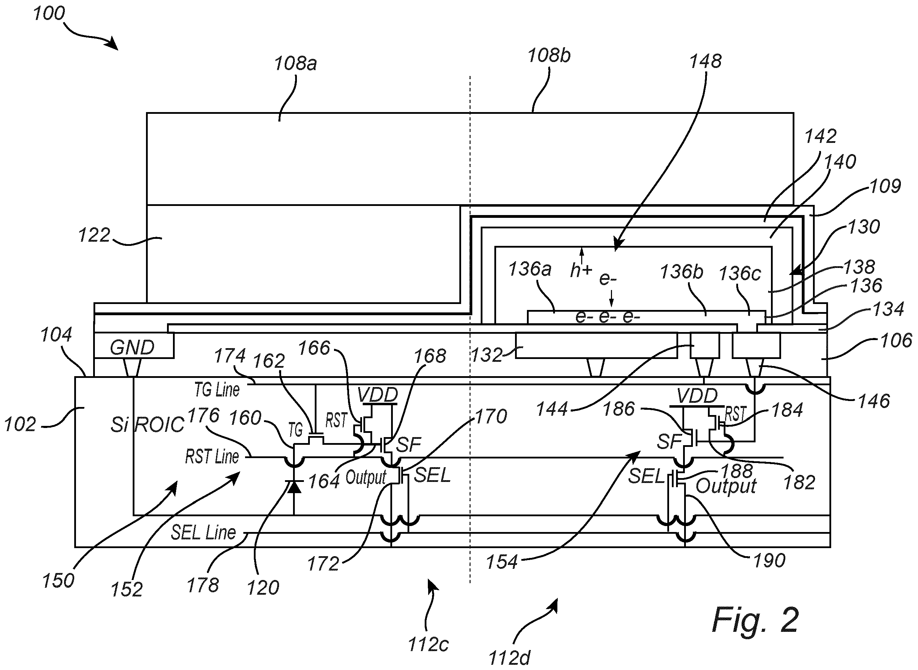

With reference to Fig. 2, the light detecting units of different types will be described in more detail. Fig. 2 is a cross-sectional view of the imaging device 100 illustrating the light detecting unit 112c of the first type and the light detecting unit 112d of the second type.

The imaging device 100 comprises the semiconductor substrate 102, which may for instance be formed by silicon. A photo-sensitive area 120 of a first type is formed in the semiconductor substrate 102. In addition, circuitry is formed in the semiconductor substrate 102, which may be used for read-out of signals from the light detecting units 112c, 112d of the first and second types. Such circuitry is also schematically indicated in Fig. 2 with the photo-sensitive area 120 of the first type also being schematically indicated being connected to the circuitry. It should be understood that this provides a functional illustration of the integrated circuit that is provided in the semiconductor substrate 110 and does not form a true representation of a cross-section of the substrate layer.

In Fig. 2, only two light detecting units 112c, 112d are shown. In the embodiment shown in Fig. 1, the light detecting units 112c, 112d are arranged in groups of 2 x 2 light detecting units 112a, 112b, 112c, 112d within the image element units 114. Thus, every other row of the array 110 may comprise alternatingly arranged light detecting units 112c of the first type and light detecting units 112d of the second type. It should be realized that light detecting units 112a, 112b of the first type configured to detect further wavelength bands within the first wavelength range may be arranged at the other rows of the array 110.

The photo-sensitive area 120 of the first type may be formed in a main surface 104 of the semiconductor substrate 102. For instance, the photo-sensitive area 120 may be formed as a pinned photodiode in the semiconductor substrate 102.

The imaging device 100 may further comprise wiring layers 106 arranged on the semiconductor substrate 102. The wiring layers 106 may be back-end-of-line layers providing contacts to circuitry components formed in the semiconductor substrate 102.

The light detecting unit 112c of the first type may further comprise a color filter 122 arranged above the wiring layers 106. The light detecting unit 112c may be configured to detect light that has passed the color filter 122 and the wiring layers 106 to reach the photo-sensitive area 120. Thus, the photo-sensitive area 120 is configured to receive incident light that has passed the color filter 122. Hence, the color filter 122 may define a wavelength band of light which is detected by the light detecting unit 112c. The color filter 122 may thus be used for selecting a wavelength band within the first wavelength range, to which the photo-sensitive area 120 is sensitive.

The light detecting unit 112d of the second type may be formed above the main surface 104 of the semiconductor substrate 102 and laterally displaced in relation to the light detecting unit 112c of the first type. The light detecting unit 112d of the second type comprises a stacked layer structure 130, which may be arranged on the back-end-of-line layers 106, as shown in Fig. 2.

The stacked layer structure 130 of the light detecting unit 112d of the second type may be suitable for being formed by thin-film layer deposition. This may ensure that the light detecting unit 112d of the second type may be very compact. It should however be realized that the stacked layer structure 130 need not necessarily be formed using thin-film layer deposition.

The stacked layer structure 130 may comprise an active layer 138, which may be configured to absorb light and generate charges based on the absorbed light. Thus, electron-hole pairs may be generated by the active layer 138 based on light being absorbed. The electron charges and hole charges may be transferred to respective charge transport layers 136, 140 on opposite sides of the active layer 138 such that the active layer 138 may be sandwiched between the charge transport layers 136, 140. Thus, generated electron charges may be transferred to an electron transport layer 136 and generated hole charges may be transferred to a hole transport layer 140.

The stacked layer structure 130 may comprise electrodes 132, 142 on opposite sides of the charge transport layers 136, 140. The electrodes 132, 142 may be configured to provide an electric field for driving charges generated in the active layer 138 towards the electron transport layer 136 and hole transport layer 140, respectively.

Thus, when light is incident on the active layer 138, charges will be generated and accumulated in the electron transport layer 136, whereas charges may be transported to the hole transport layer 140 and be drained through the electrode 142. The accumulation of charges in the electron transport layer 136 and the hole transport layer 140 prevents or at least reduces recombination of holes and electrons in the active layer 138 to ensure that a high efficiency in light detection is provided by the light detecting unit 112d of the second type.

The active layer 138 may be sensitive to a particular, that is a specific, predetermined or selective, range of wavelengths of light, forming the second wavelength range. The second wavelength range may be narrow to allow detection of a specific wavelength, but the second wavelength range may alternatively be broad such that the light detecting unit 112d of the second type may be able to generally detect an amount of light over a broad range, such as covering a range of infrared light, such as short-wave infrared light. The light detecting unit 112d of the second type may also be combined with a filter such that the filter may select a wavelength band that should be detected by the light detecting unit 112d. Also, having an active layer 138 which is sensitive to a broad second wavelength range would allow using the same type of active layer 138 within the array 110, wherein different light detecting units of the second type in the array 110 may be associated with different filters for providing further options for spectrally resolved imaging.

In particular, the active layer 138 may be formed from a material which is sensitive to wavelengths in the infrared range. However, it should be understood that the light detecting unit 112d of the second type may also be well suited for detection of visible light by proper selection of the active layer 138.

The active layer 138 may be formed from various different materials. In particular, the light detecting unit 112d of the second type is well suited for using an organic material in the active layer 138, such as an organic semiconductor material.

The active layer 138 may, for example, comprise a quantum dot, an organic photodetector material or a perovskite material. Such materials may be suitable for use in manufacturing of the stacked layer structure 130 using thin-film technology. Also, such materials may be used for selecting a sensitivity of wavelengths of light of the light detecting unit 112d of the second type to enable using the light detecting unit 112d of the second type in various different applications spanning a broad range of wavelengths of light from ultraviolet light to infrared light.

However, it should be understood that the light detecting unit 112d of the second type is not necessarily limited to use of the particular examples of materials of the active layer 138 provided herein. Rather, other materials may also be available and used with the light detecting unit 112d of the second type.

The light to be detected may be incident on a top electrode 142 arranged above the active layer 138 and farther away from the semiconductor substrate 102 than a bottom electrode 132. Thus, light may encounter the top electrode 142 before reaching the active layer 138.

The top electrode 142 may be formed from a material that is transparent to relevant wavelengths (to be detected by the light detecting unit 112d of the second type) to ensure that the light is passed to the active layer 138 for detection with high sensitivity. For instance, the top electrode 142 may be formed by indium tin oxide.

The electrodes 132, 142 may be configured to control a potential of the charge transport layers 136, 140 to control function of the light detecting unit 112d of the second type. The top electrode 142 sets a potential of the charge transport layer 140 above the active layer 138 and a bottom electrode 132 sets a potential of the charge transport layer 136 below the active layer 138.

The bottom electrode 132 arranged below the active layer 138 and below the charge transport layer 136 may be formed as a gate for controlling the potential of the charge transport layer 136 and may be referred to interchangeably herein as the gate 132. The gate 132 may thus be separated from the charge transport layer 136 by a dielectric material 134.

The bottom electrode 132 may e.g. be formed by a gate metal or polysilicon or a transparent material such as indium tin oxide. The bottom electrode 132 may be separated by a layer of a dielectric material 134, such as SiO₂, from the charge transport layer 136. The bottom electrode 132 may thus be well suited for being formed by semiconductor processing on a semiconductor substrate 102, which may be combined with the remaining layers of the stacked layer structure 130 by forming these layers on top of the semiconductor substrate 102 using thin-film layer deposition.

The gate 132 may be arranged below a first portion 136a of the charge transport layer 136 to control a potential of the first portion 136a, which may form a first node of the stacked layer structure 130.

The charge transport layer 136 may comprise the first portion 136a, a transfer portion 136b and a second portion 136c, which are arranged in different lateral areas of a plane of the charge transport layer 136. The second portion 136c of the charge transport layer 136 may form a second node of the stacked layer structure 130.

The charge transport layer 136 may further be configured to be controlled for controlling accumulation of charges in the first portion 136a and controlling transfer of charges from the first portion 136a to the second portion 136c via the transfer portion 136b. The control of the charge transport layer 136 may be provided by the gate 132 for controlling a potential of the first portion 136a and a transfer gate 144 for controlling a potential of the transfer portion 136b.

The transfer gate 144 may be arranged adjacent to the gate 132 and may be separated by the same layer of dielectric material 134 from the charge transport layer 136. The transfer gate 144 may e.g. be formed by a gate metal or polysilicon.

The transfer gate 144 may be configured to control transfer of charges from the first portion 136a to the second portion 136c. Thus, a signal may be provided to the transfer gate 144 to allow or prevent charges to be transferred from the first portion 136a to the second portion 136c.

The second portion 136c may be connected to a floating diffusion node for read-out of a signal representing an amount of light detected by the light detecting unit 112d of the second type. The transfer gate 144 may thus be switched ON or OFF to connect (or disconnect) the light detecting unit 112d of the second type to the floating diffusion node.

The transfer gate 144 may be arranged below the charge transport layer 136. However, alternative arrangements of the transfer gate 144 may be provided.

For instance, the transfer gate 144 may be arranged above the transfer portion 136b of the charge transport layer 136 forming a front-gate type transistor. In such case, a layer of dielectric material may be arranged between the charge transport layer 136 and the transfer gate 144.

Alternatively, the transfer gate 144 may comprise a first portion and a second portion, wherein the first portion of the transfer gate 144 is arranged above the charge transport layer 136 and the second portion of the transfer gate 144 is arranged below the charge transport layer 136. Thus, the transfer gate 144 may form a dual-gate type transistor.

The gate 132 and the transfer gate 144 may be provided with voltage signals for controlling potentials of the first portion 136a and the transfer portion 136b, respectively, of the charge transport layer 136. The voltage signals may be set such that, when the charges are removed from the first portion 136a by switching on the transfer gate 144, the charges may be completely removed from the first portion 136a of the charge transport layer 136.

Thus, a potential of the first portion 136a of the charge transport layer 136 may be modulated from below the charge transport layer 136, which may be used to ensure full depletion of the first portion 136a. The modulation of the potential of the first portion 136a of the charge transport layer 136 may be achieved without affecting the read-out of signals from the charge transport layer 136.

Full depletion is beneficial in providing good noise characteristics of the light detecting unit 112d of the second type, which may be useful in e.g. providing high image quality based on detection of light by the array 110.

The full depletion of the first portion 136a allows reset noise of the light detecting unit 112d of the second type, i.e. a signal level of the light detecting unit 112d of the second type remaining after reset of a floating diffusion node, to be limited. Also, a dark current, i.e. a current signal when no light is incident on the light detecting unit 112d of the second type, may be limited. Further, the light detecting unit 112d of the second type may provide a high conversion gain.

The charge transport layer 136 may be configured to accumulate charges in the first portion 136a. Thus, the first portion 136a may be arranged below the active layer 138 and may be covered by the active layer 138. The active layer 138, the charge transport layer 140 and the top electrode 142 may be arranged above only the first portion 136a of the charge transport layer 136. In other words, a projection of the active layer 138, the charge transport layer 140 and the top electrode 142 onto the plane of the charge transport layer 136 may cover only the first portion 136a of the charge transport layer 136 (or a part of the first portion 136a). This implies that the charges will only be accumulated in the first portion 136a of the charge transport layer 136. However, as illustrated in Fig. 2, the active layer 138, the charge transport layer 140 and the top electrode 142 may alternatively be arranged above further parts of the charge transport layer 136, such as extending over the entire charge transport layer 136. The potential in different parts of the stacked layer structure 130 may be controlled such that, during an integration period, charges accumulate in the first portion 136a of the charge transport layer 136 and are prevented from reaching the second portion 136c of the charge transport layer 136, whereas, during transfer of charges, the accumulated charges in the first portion 136a are transferred to the second portion 136c.

The second portion 136c of the charge transport layer 136 may be connected to a floating diffusion node 182 of read-out electronics 150. The second portion 136c may be connected through a via 146 extending through back-end-of-line layers 106 arranged on the semiconductor substrate 102, so as to be connected to a node in a metal layer, which forms the floating diffusion node 182.

It should be realized that the stacked layer structure 130 of the light detecting unit 112d may be arranged in various, alternate and/or different relations to the read-out electronics 150. For instance, the stacked layer structure 130 may be arranged above the read-out electronics 150 on the semiconductor substrate 102. However, in another embodiment, the read-out electronics 150 may be arranged in a separate area of the substrate 102 and need not be arranged below the stacked layer structure 130. Rather, signals from the second portion 136c of the charge transport layer 136 may be transported in a lateral direction of the semiconductor substrate 102 to the read-out electronics 150.

According to an embodiment, the charge transport layer 136 arranged below the active layer 138 is an electron transport layer 136.

The electron transport layer 136 may be formed by a n-type metal-oxide semiconductor. Various alternatives exist, such as indium-gallium-zinc oxide (IGZO), e.g. amorphous IGZO, indium-tin-zinc-oxide or hafnium-indium-zinc-oxide.

In such embodiment, the charge transport layer 140 arranged above the active layer 138 may be a hole transport layer 140.

According to another embodiment, the charge transport layer 136 arranged below the active layer 136 is a hole transport layer 136.

The hole transport layer 136 may be formed by a p-type metal-oxide semiconductor. Various alternatives exist, such as tin-oxide, copper-oxide, selenides, and sulfides.

In such embodiment, the charge transport layer 140 arranged above the active layer 138 may be an electron transport layer 140.

It should be realized that the stacked layer structure 130 may be arranged in different ways, using fewer or more layers. The potentials in different parts of the stacked layer structure 130 may be controlled in different manners, using fewer layers and not necessarily using layers or structures dedicated to the stacked layer structure 130. Thus, electrodes may not necessarily form part of the stacked layer structure 130.

According to an embodiment, the stacked layer structure 130 need not comprise any charge transport layer. Rather, the stacked layer structure 130 may be controlled by electrode layer(s) for controlling potentials within the active layer 138 of the stacked layer structure 130. Thus, the first node and the second node of the stacked layer structure 130 may be defined in a lower portion of the active layer 138 closest to the main surface 104 of the semiconductor substrate 102, wherein the lower portion extends along a plane of the active layer 138. This implies that charges may be accumulated and transported within the active layer 138 instead of in a charge transport layer. However, it should be realized that the charge transport layers may have dedicated characteristics for transporting charges such that the signal representative of light incident on the light detecting unit 112d of the second type may have a better signal-to-noise ratio if a dedicated charge transport layer is used.

The light detecting unit 112d of the second type defines a photo-sensitive area 148 of a second type, in which charges will be generated in response to incident light and be accumulated for later read-out. The photo-sensitive area 148 may correspond to an area of the active layer 138 in the plane of the active layer 138. However, the entire active layer 138 may not contribute to accumulated charges, e.g., if the active layer 138 extends over the entire charge transport layer 136. Thus, the photo-sensitive area 148 may correspond approximately to an area of the active layer 138 that is projected onto the first portion 136a of the charge transport layer 136.

A projection of the photo-sensitive area 148 of the second type onto the main surface 104 of the semiconductor substrate 102 is displaced in relation to the photo-sensitive area 120 of the first type. This implies that the photo-sensitive areas 120, 148 of the first and second types are configured to detect spatially separate light. Hence, optical components may be provided in separate paths of light for affecting or controlling light to be detected by the photo-sensitive area 120 of the first type or light to be detected by the photo-sensitive area 148 of the second type, respectively. This may imply that the light being detected by the respective light detecting units 112c, 112d of the first and second types may be accurately controlled such that light may be detected with a high signal-to-noise ratio.

The imaging device 100 may thus comprise a first wavelength filter 108a associated with the light detecting units 112a, 112b, 112c of the first type and arranged such that the photo-sensitive area 120 of the first type is configured to receive incident light having passed the first wavelength filter 108a. The imaging device 100 may further comprise a second wavelength filter 108b associated with the light detecting units 112d of the second type and arranged such that the photo-sensitive area 148 of the second type is configured to receive incident light having passed the second wavelength filter 108b.

The first wavelength filter 108a may be configured as a cut-off filter so as to block light above a cut-off wavelength. If the light detecting units 112a, 112b, 112c of the first type are configured to detect visible light, the first wavelength filter 108a may be an infrared cutoff filter. The first wavelength filter 108a may thus pass light within the first wavelength range intended to be detected by the light detecting units 112a, 112b, 112c of the first type. The first wavelength filter 108a may reflect or absorb light above the cut-off wavelength such that the first wavelength filter 108a may substantially or completely reduce transmission of light in the second wavelength range to be detected by the light detecting units 112d of the second type. This implies that crosstalk from light detecting units 112a, 112b, 112c of the first type to the light detecting units 112d of the second type may be avoided.

The second wavelength filter 108b may be configured as a cut-off filter so as to block light below a cut-off wavelength. If the light detecting units 112d of the second type are configured to detect infrared light, the second wavelength filter 108b may be a visible light cutoff filter. The second wavelength filter 108b may thus pass light within the second wavelength range intended to be detected by the light detecting units 112d of the second type. The second wavelength filter 108b may reflect or absorb light below the cut-off wavelength such that the second wavelength filter 108b may substantially or completely reduce transmission of light in the first wavelength range to be detected by the light detecting units 112a, 112b, 112c of the first type. This implies that crosstalk from light detecting units 112d of the second type to the light detecting units 112a, 112b, 112c of the second type may be avoided.

The light detection units 112a, 112b, 112c of the first type may be displaced in relation to the light detecting units 112d of the second type within an image element unit 114. However, the light detecting units 112a, 112b, 112c, 112d of the different types are arranged in close relation to each other, such that although the light detecting units 112a, 112b, 112c, 112d detect spatially separate light, the origin of the light being detected by the different light detecting units 112a, 112b, 112c, 112d may be almost the same. This implies that the image element unit 114 may be used for representing a single spatial location of an object or scene being imaged, with a spectral resolution given by the light detecting units 112a, 112b, 112c, 112d forming the image element unit 114.

A size of the photo-sensitive areas 120, 148 of the first and second types may be identical. This implies that the array 110 may comprise a regular arrangement of light detecting units 112a, 112b, 112c, 112d. However, according to an alternative, a size of the photo-sensitive area 148 of the second type is larger than a size of the photo-sensitive area 120 of the first type. For instance, when the light detecting units 112d of the second type are used for detecting infrared light and the light detecting units 112a, 112b, 112c of the first type are used for detecting visible light, this may ensure that similar signal-to-noise ratio is provided for the light detecting units 112a, 112b, 112c, 112d of the first and second types.

The imaging device 100 may further comprise a protection layer 109 providing a protection of the stacked layer structure 130 so as to ensure that the stacked layer structure 130 is not damaged by manufacturing steps performed after the stacked layer structure 130 has been formed.

The protection layer 109 may be arranged as a sheet extending over the entire array 110. This implies that the protection layer 109 may be easily provided and no further patterning of the protection layer 109 is needed. However, the protection layer 109 may alternatively be patterned so as to only be arranged above the stacked layer structures 130 of the light detecting units 112d of the second type and cover the stacked layer structures 130.

The protection layer 109 may be transparent to both the first and second wavelength ranges so as not to affect detection of light by the light detecting units 112a, 112b, 112c, 112d.

The protection layer 109 may be formed at a fairly low temperature which will not harm the stacked layer structure 130 underneath the protection layer 109 during deposition of the protection layer 109. Further, the protection layer 109 may be sufficiently inert for following patterning and etching process for forming color filters 122. As shown in Fig. 2, the protection layer 109 may be arranged between the color filter 122 and the photo-sensitive area 120 of the first type.

The protection layer 109 may for instance be formed by a passivation layer, such as an aluminum oxide layer.

As shown in Fig. 2, the imaging device 100 comprises read-out electronics 150. The read-out electronics 150 comprises a first portion 152 associated with the light detecting units 112a, 112b, 112c of the first type, wherein identical read-out units are provided for each of the light detecting units 112a, 112b, 112c of the first type. The read-out electronics 150 further comprises a second portion 154 associated with the light detecting units 112d of the second type, wherein identical read-out units are provided for each of the light detecting units 112d of the second type.

The first portion 152 and the second portion 154 of the read-out electronics 150 are configured in a similar manner such that at least some control signals for controlling read-out may be shared or may at least be provided with a common timing for both the first portion 152 and the second portion 154. In particular, the first portion 152 and the second portion 154 may receive control signals with a common timing for simultaneous read-out of signals from the light detecting units 112a, 112b, 112c of the first type and the light detecting units 112d of the second type.

The read-out electronics 150 may comprise a read-out integrated circuit which may be formed by semiconductor technology in the semiconductor substrate 102, such as using complementary metal-oxide-semiconductor (CMOS) circuitry.

In the embodiment, shown in Fig. 2, the read-out electronics 150 comprises four transistors per read-out unit. A four transistor (4T) architecture may provide a high signal-to-noise ratio as noise levels may be low. Thus, the 4T architecture may be preferred. Thanks to the control of transfer of accumulated charges between the first node and the second node, such as the first portion 136a and the second portion 136c of the charge transport layer 136, the read-out from the light detecting units 112d of the second type may be controlled based on a control signal scheme for the 4T architecture. Thus, the transfer gate 144 of the light detecting unit 112d of the second type may provide control corresponding to a transistor for controlling transfer of charges.

The 4T architecture of the first portion 152 of the read-out electronics 150 may comprise an internal node 160 directly connected to a photodiode formed by the photo-sensitive area 120 of the first type. The photodiode may provide an accumulated charge signal at the internal node 160. This implies that the charge signal may be accumulated during an integration time period.

The 4T architecture may comprise a transfer transistor 162. The transfer transistor 162 may be an n-type metal-oxide-semiconductor (NMOS) transistor having a drain connected to the internal node 160 and a source connected to a floating diffusion node 164. It should be realized that the transfer transistor 162 may alternatively be a p-type metal-oxide-semiconductor (PMOS) transistor with a source connected to the internal node 160 and a drain connected to the floating diffusion node 164.

The transfer transistor 162 comprises a gate configured to receive a first control signal. The first control signal may be configured to control operation of the transfer transistor 162. The first control signal may be configured to control the first transistor 162 to act as a switch selectively connecting the internal node 160 to the floating diffusion node 164.

The 4T architecture further comprises a reset transistor 166. The reset transistor 166 may be an NMOS transistor comprising a drain connected to a constant voltage and a source connected to the floating diffusion node 164. The reset transistor 166 may alternatively be a PMOS transistor with a source connected to the constant voltage and the drain connected to the floating diffusion node 164.

The reset transistor 166 comprises a gate configured to receive a second control signal. The second control signal may be configured to control operation of the reset transistor 166. The second control signal may be configured to control the reset transistor 166 to act as a switch for selectively resetting the voltage at the floating diffusion node 164.

The 4T architecture further comprises an amplifier transistor 168, which may also be referred to as a source follower, and a select transistor 170. The amplifier transistor 168 comprises a gate which is connected to the floating diffusion node 164. The amplifier transistor 168 may be configured to amplify the signal on the floating diffusion node 164.

The amplifier transistor 168 may be an NMOS transistor comprising a drain connected to a constant bias voltage and a source connected to the select transistor 170. The constant bias voltage may for instance be a positive supply voltage, denoted VDD. The amplifier transistor 168 may alternatively be a PMOS transistor comprising a source connected to the constant bias voltage and a drain connected to the select transistor 170.

The select transistor 170 may be an NMOS transistor comprising a drain connected to the amplifier transistor 168 and a source connected to an output node 172. The amplifier transistor 168 and the select transistor 170 may be connected such that in case NMOS transistors are used, the source of the amplifier transistor 168 is connected to the drain of the select transistor 170 and in case PMOS transistors are used, the drain of the amplifier transistor 168 is connected to the source of the select transistor 170.

The select transistor 170 comprises a gate configured to receive a third control signal. The third control signal may be configured to control operation of the select transistor 170. The third control signal may be configured to control the select transistor 170 to act as a switch selectively connecting the amplifier transistor 168 to the output node 172.

Thus, the 4T architecture may be configured to control transfer of charges from the photo-sensitive area 120 to a floating diffusion node 164, reset of the floating diffusion node 164, source-follower readout, and selection of read-out from the light detecting unit 112a, 112b, 112c.

The second portion 154 of the read-out electronics 150 may be very similar to the first portion 152. The second portion 154 of the read-out electronics 150 may comprise the transfer gate 144 which controls transfer of accumulated charges for providing a signal to the floating diffusion node 182, which may be arranged in the read-out integrated circuit formed in the semiconductor substrate 102.

Apart from the arrangement of the transfer gate 144, the second portion 154 of the read-out electronics 150 may be identical to the first portion 152. Thus, the second portion 154 may comprise a reset transistor 184 connected to selectively reset the floating diffusion node 182, an amplifier transistor 186 having a gate connected to the floating diffusion node 182 and configured to amplify the signal on the floating diffusion node 182, a select transistor 188 connected to the amplifier transistor 188 and configured to selectively connect the amplifier transistor 186 to an output node 190 for output of a signal from the light detecting unit 112d of the second type.

As shown in Fig. 2, the first portion 152 and the second portion 154 of the read-out electronics 150 may share control lines providing control signals for controlling detection and read-out of signals from the light detecting units 112a, 112b, 112c, 112d. However, it should be realized that separate control lines may be provided, wherein at least the first control signal for read-out of a signal from the light detecting units 112a, 112b, 112c, 112d to a floating diffusion node 164, 182 may have a common timing.

As shown in Fig. 2, the first control signal may be provided on a first control line 174. The first control line 174 may be connected to the gate of the transfer transistor 162 and may also be connected to the transfer gate 144 of the light detecting unit 112d of the second type. The first control line 174 may be configured to extend along a row of the array 110, such that separate control lines for providing the first control signal may be provided for each row of the array 110.

Further, the second control signal may be provided on a second control line 176. The second control line 176 may be connected to the gate of the reset transistor 166 of the first portion 152 and to the gate of the reset transistor 184 of the second portion 154. The second control line 176 may be configured to extend along a row of the array 110, such that separate control lines for providing the first control signal may be provided for each row of the array 110.

Further, the third control signal may be provided on a third control line 178. The third control line 178 may be connected to the gate of the select transistor 170 of the first portion 152 and to the gate of the select transistor 188 of the second portion 154. The third control line 178 may be configured to extend along a row of the array 110, such that separate control lines for providing the first control signal may be provided for each row of the array 110.

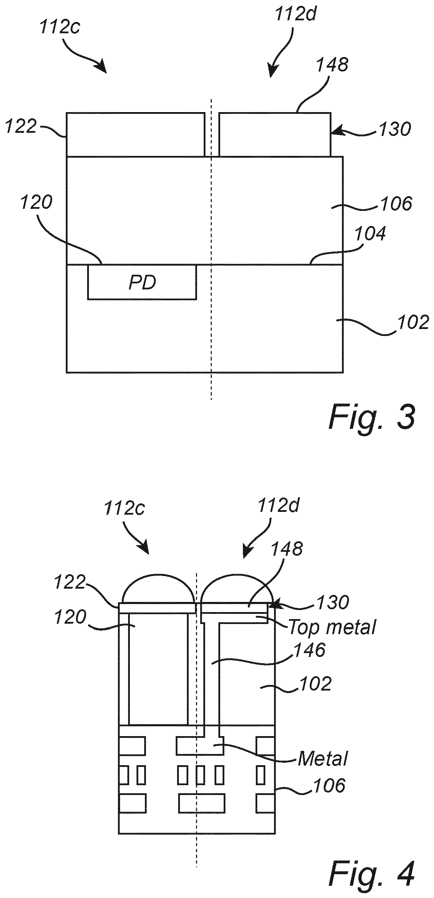

Referring now to Fig. 3, arrangement of the light detecting units 112c, 112d in relation to wiring layers 106 (back-end-of-line layers) on the semiconductor substrate 102 is shown for an imaging device 100 being configured for front-side illumination.

As shown in Fig. 3, the photo-sensitive area 120 of the light detecting unit 112c of the first type is formed in the semiconductor substrate 102. The wiring layers 106 are arranged above the photo-sensitive area 120. Thus, light to be detected by the light detecting unit 112c will pass through the wiring layers and may partly affect the light that is detected. The color filter 122 may be arranged above the wiring layers 106. Further, the stacked layer structure 130 of the light detecting unit 112d of the second type may be arranged above the wiring layers 106, such that light detected by the photo-sensitive area 148 of the second type is not affected by the wiring layers 106.

The second portion 136c of the charge transport layer 136 may be connected through the via 146 extending through wiring layers 106 for providing a signal to the floating diffusion node 182.

Referring now to Fig. 4, an alternative arrangement of the light detecting units 112c, 112d in relation to wiring layers 106 (back-end-of-line layers) is shown for an imaging device 100 being configured for back-side illumination.

As shown in Fig. 4, the photo-sensitive area 120 of the light detecting unit 112c of the first type is formed in the semiconductor substrate 102. The semiconductor substrate 102 is thinned and flipped such that light is incident on the semiconductor substrate 102 from a back side. The wiring layers 106 are arranged below the photo-sensitive area 120. Thus, light to be detected by the light detecting unit 112c will not pass through any wiring layers before being detected by the photo-sensitive area 120. The color filter 122 may be arranged directly above the photo-sensitive area 120. Further, the stacked layer structure 130 of the light detecting unit 112d of the second type may be arranged directly on the main surface of the semiconductor substrate 102, which is now defined by the back side of the substrate 102.

The second portion 136c of the charge transport layer 136 may be connected through the via 146 extending through the semiconductor substrate 102 for providing a signal to the floating diffusion node 182.

The imaging device being configured for back-side illumination may detect a larger proportion of incident light compared to front-side illumination. Thus, the imaging device configured for back-side illumination may be advantageously used for imaging in low light conditions.

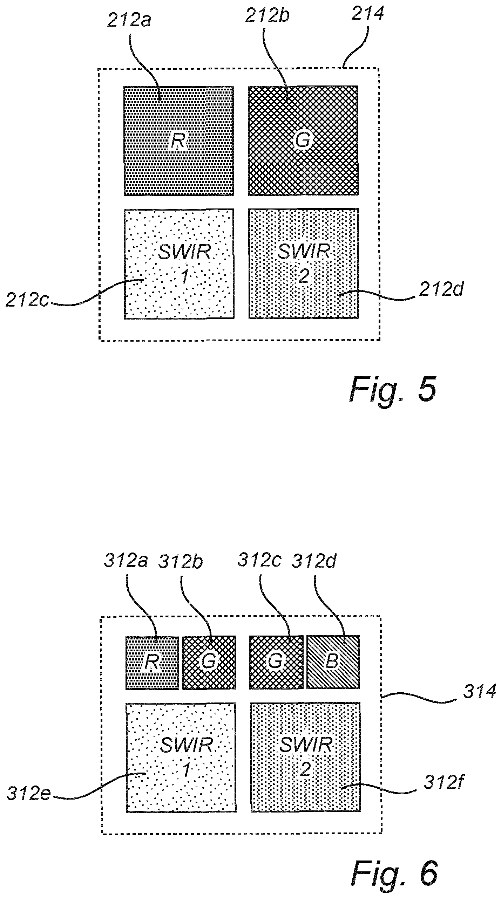

Referring now to Fig. 5, an alternative layout of image element units 214 is shown. The image element unit 214 may be used with any of the embodiments of the imaging device 100 described above.

As shown in Fig. 5, the image element unit 214 may comprise light detecting units 212a, 212b of a first type arranged in a first row and light detecting units 212c, 212d of a second type arranged in a second row. This may facilitate providing control signals on different control lines to the light detecting units 212a, 212b of the first type and to the light detecting units 212c, 212d of the second type, respectively.

The light detecting units 212a-d are shown to have an equal size. This may facilitate arranging of the light detecting units 212a-d in a regular manner forming a regular array.

The light detecting units 212c, 212d of the second type may be configured to detect infrared light, whereas the light detecting units 212a, 212b may be configured to detect visible light, herein illustrated as detecting red and green light, respectively. The sensitivity of the light detecting units 212c, 212d of the second type to incident infrared light may be lower than the sensitivity of the light detecting units 212a, 212b of the first type to incident visible light. Since the light detecting units 212a-d have an equal size, the light detecting units 212c, 212d of the second type may have a lower signal-to-noise ratio than the light detecting units 212a, 212b of the first type. This may be compensated for by using a longer integration time for the light detecting units 212c, 212d of the second type than the integration time for the light detecting units 212a, 212b of the first type.

The longer integration time may be controlled by using different timing of a reset signal for the read-out electronics associated with the light detecting units 212a, 212b of the first type and the light detecting units 212c, 212d of the second type, respectively. This may be provided by the light detecting units 212a, 212b of the first type being controlled by different control lines than the light detecting units 212c, 212d of the second type, at least by different control lines for controlling reset.

The light detecting units 212a-d of both types may receive control signals with a common timing for controlling simultaneous read-out of signals from the light detecting units 212a-d. Thus, the control signals for controlling transfer transistors of the light detecting units 212a, 212b of the first type may be simultaneous with control signals for controlling transfer gates of the light detecting units 212c, 212d of the second type.

As shown in Fig. 5, the image element unit 214 comprises two different light detecting units 212c, 212d of the second type. It should be realized that the light detecting units 212c, 212d of the second type may be configured to detect different wavelength bands within the second wavelength range. This may be achieved, for instance, by the light detecting units 212c, 212d of the second type being associated with different wavelength filters for controlling the wavelength band being detected.

However, according to an alternative, the light detecting units 212c, 212d of the second type may be formed by different materials. For instance, the active layer of the respective light detecting units 212c, 212d may be formed by different materials. The light detecting units 212c, 212d may thus be configured to detect light of different short-wave infrared (SWIR) wavelength bands, indicated as SWIR1 and SWIR2 in Fig. 5.

Referring now to Fig. 6, another alternative layout of image element units 314 is shown. The image element unit 314 may be used with any of the embodiments of the imaging device 100 described above.

As shown in Fig. 6, the image element unit 214 may comprise light detecting units 312a, 312b, 312c, 312d of a first type arranged in a first row and light detecting units 312e, 312f of a second type arranged in a second row. This may be useful for providing a regular arrangement of the light detecting units 312a-f in the array, while having different sizes of the light detecting units 312a-d of the first type and the light detecting units 312e-f of the second type.

The light detecting units 312e, 312f of the second type may be configured to detect infrared light, whereas the light detecting units 312a-d may be configured to detect visible light. The light detecting units 312a-d may have comprise one light detecting unit 312a for detecting red light, two light detecting units 312b, 312c for detecting green light and one light detecting unit 312d for detecting blue light corresponding to a conventional detection of visible light. The sensitivity of the light detecting units 312e, 312f of the second type to incident infrared light may be lower than the sensitivity of the light detecting units 312a-d of the first type to incident visible light. The difference in sensitivity is compensated for by a size of the photo-sensitive areas of the light detecting units 312e, 312f of second type being larger than a size of the photo-sensitive areas of the light detecting units 312a-d of the first type.

Since different sizes of the light detecting units 312a-f of different types are used, all light detecting units 312a-f may be controlled based on a common control signal scheme, such as a control signal scheme for the 4T architecture.

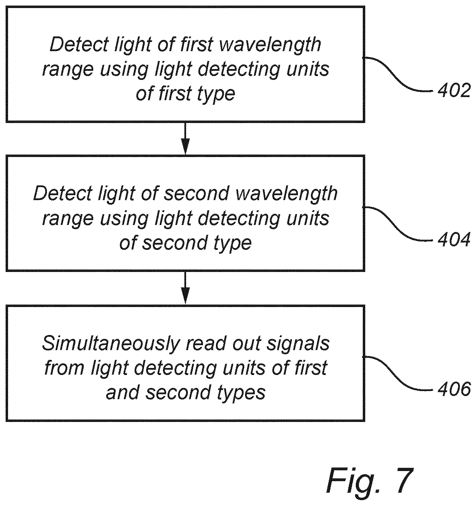

Referring now to Fig. 7, a method for imaging using the imaging device will be described.

The method comprises detecting 402 light of a first wavelength range using light detecting units of a first type. Each light detecting unit of the first type comprises a photo-sensitive area of a first type formed in or at a main surface of a semiconductor substrate.

The method further comprises detecting 404 light of a second wavelength range using light detecting units of a second type. Each light detecting unit of the second type comprises a stacked layer structure formed on the main surface of the semiconductor substrate. The stacked layer structure comprises an active layer, which forms a photo-sensitive area of a second type and is configured to generate charges in response to incident light, and a charge transport layer for transporting charges generated by the active layer.

The light detecting units of the first type and the light detecting units of the second type are thus configured to detect light of different wavelength ranges so as to, in combination, be configured to provide detection of light in a broad range of wavelengths.

The light detecting units of the first type and light detecting units of the second type are arranged displaced in relation to each other in a direction along the surface of the semiconductor substrate such that the photo-sensitive areas of the first type are configured to detect light that is spatially separate from light detected by the photo-sensitive areas of the second type. This implies that the light to be detected by the light detecting unit of the different types may be separately controlled for providing control of light that is suited for the respective light detecting units.

The method further comprises simultaneously reading out 406 signals representative of light incident on the light detecting units of the first type and light incident on the light detecting units of the second type. Thus, the method allows using different types of light detecting units, while read out is performed simultaneously. This may be achieved by providing control signals with a common timing to the light detecting units of the first and second types.

Thanks to the simultaneous read-out, information of an object or scene being image may be acquired simultaneously for different wavelength bands. Thus, there is no motion blur between information in different wavelength bands. In addition, separate frames need not be acquired for different wavelength bands. This implies that a longer maximum integration time may be used for a fixed frame rate compared to an imaging device wherein separate frames are used for reading out different wavelength bands. Alternatively, a higher frame rate may be used.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. An imaging device (100) comprising:
a semiconductor substrate (102); and
an array (110) of light detecting units (112a-d; 212a-d; 312a-f) for sensing light incident on the light detecting units (112a-d; 212a-d; 312a-f),
wherein the array (110) comprises light detecting units (112a-c; 212a-b; 312a-d) of a first type for detecting light in a first wavelength range, wherein each light detecting unit (112a-c; 212a-b; 312a-d) of the first type comprises a photo-sensitive area (120) of a first type formed in or at a main surface (104) of the semiconductor substrate (102),
wherein the array (110) further comprises light detecting units (112d; 212c-d; 312e-f) of a second type for detecting light in a second wavelength range different from the first wavelength range, wherein each light detecting unit (112d) of the second type comprises a stacked layer structure (130) formed on the main surface (104) of the semiconductor substrate (102), wherein the stacked layer structure (130) comprises an active layer (138), which forms a photo-sensitive area (148) of a second type and is configured to generate charges in response to incident light, wherein the stacked layer structure (130) is configured to control transporting of charges generated by the active layer (138);
wherein the light detecting units (112a-c; 212a-b; 312a-d) of the first type and light detecting units (112d; 212c-d; 312e-f) of the second type are arranged displaced in relation to each other in a direction along the main surface (104) of the semiconductor substrate (102) such that the photo-sensitive areas (120) of the first type are configured to detect light that is spatially separate from light detected by the photo-sensitive areas (148) of the second type;
wherein the imaging device (100) further comprises read-out electronics (150) for read out of signals representative of light incident on the light detecting units (112a-d; 212a-d; 312a-f), wherein a first portion (152) of the read-out electronics (150) associated with the light detecting units (112a-c; 212a-b; 312e-f) of the first type and a second portion (154) of the read-out electronics (150) associated with the light detecting units (112d; 212c-d; 312e-f) of the second type are configured to receive control signals with a common timing such that signals from the light detecting units (112a-c; 212a-b; 312a-d) of the first type and the light detecting units (112d; 212c-d; 312e-f) of the second type are read out simultaneously.

2. The imaging device according to claim 1, wherein the stacked layer structure (130) of light detecting units (112d; 212c-d; 312e-f) of the second type comprises a charge transport layer (136) comprising a first portion (136a) and a second portion (136c), the second portion (136c) being displaced along a plane of the charge transport layer (136) in relation to the first portion (136a), wherein the light detecting units (112d; 212c-d; 312e-f) of the second type are configured to accumulate charges generated by the active layer (138) in the first portion (136a) of the charge transport layer (136), wherein the read-out electronics (150) for each light detecting unit (112d; 212c-d; 312e-f) of the second type comprises a transfer gate (144) separated by a dielectric material (134) from a transport portion (136b) of the charge transport layer (136) between the first portion (136a) and the second portion (136c), wherein the transfer gate (144) is configured to control transfer of accumulated charges in the first portion (136a) to the second portion (136c).

3. The imaging device according to claim 2, wherein the second portion (136c) of the charge transport layer (136) is connected through a via (146) extending through layers in a direction perpendicular to the charge transport layer (136) to a metal layer on the semiconductor substrate (102) forming a floating diffusion node (182) of the read-out electronics (150).

4. The imaging device according to any one of the preceding claims, wherein the read-out electronics (150) comprises four transistors (162, 166, 168, 170; 144, 184, 186, 188) associated with each light detecting unit (112a-c; 212a-b; 312a-d) of the first type and each light detecting unit (112d; 212c-d; 312e-f) of the second type, wherein the four transistors (162, 166, 168, 170; 144, 184, 186, 188) are configured to control transfer of charges from the photo-sensitive area (120; 148) to a floating diffusion node (164; 182), reset of the floating diffusion node (164; 180), source-follower readout, and selection of read-out from the light detecting unit (112a-d; 212a-d; 312a-f).

5. The imaging device according to any one of the preceding claims, wherein the read-out electronics (150) comprises read-out integrated circuit formed in the semiconductor substrate (102).

6. The imaging device according to claim 5, wherein the imaging device (100) is configured for front-side illumination, wherein the imaging device (100) comprises wiring layers (106) providing electrical connection to the read-out integrated circuit, wherein the photo-sensitive areas (120) of the first type are arranged to detect light having passed the wiring layers (106).

7. The imaging device according to claim 5, wherein the imaging device (100) is configured for back-side illumination, wherein the imaging device (100) comprises wiring layers (106) providing electrical connection to the read-out integrated circuit, wherein the photo-sensitive areas (120) of the first type and the photo-sensitive areas (148) of the second type are arranged on an opposite side of the read-out integrated circuit to the wiring layers (106).

8. The imaging device according to any one of the preceding claims, wherein each light detecting unit (112a-c; 212a-b; 312a-d) of the first type comprises a color filter (122) arranged in relation to the photo-sensitive area (120) of the first type such that the photo-sensitive area (120) of the first type is configured to receive incident light having passed the color filter (122).

9. The imaging device according to claim 8, further comprising a protection layer (109) arranged on the stacked layer structure (130) of each light detecting unit (112d; 212c-d; 312e-f) of the second type, wherein the protection layer (109) further extends between the color filter (122) and the photo-sensitive area (120) of the first type.

10. The imaging device according to any one of the preceding claims, further comprising a first wavelength filter (108a) associated with the light detecting units (112a-c; 212a-b; 312a-d) of the first type and arranged such that the photo-sensitive area (120) of the first type is configured to receive incident light having passed the first wavelength filter (108a), and a second wavelength filter (108b) associated with the light detecting units (112d; 212c-d; 312e-f) of the second type and arranged such that the photo-sensitive area (148) of the second type is configured to receive incident light having passed the second wavelength filter (108b), wherein the first wavelength filter (108a) is configured to block infrared light and the second wavelength filter (108b) is configured to block visible light.

11. The imaging device according to any one of the preceding claims, wherein the array (110) of light detecting units (112a-d; 212a-d; 312a-f) comprises a plurality of image element units (114; 214; 314) being repeated across the array (110), wherein each image element unit (114; 214; 314) comprises at least one light detecting unit (112a-c; 212a-b; 312a-d) of the first type and at least one light detecting unit (112d; 212c-d; 312e-f) of the second type.

12. The imaging device according to claim 11, wherein each image element unit (114) comprises a plurality of light detecting units (112a-c) of the first type, such as three light detecting units (112a-c) of the first type configured to detect red, green, and blue light, respectively and one light detecting unit (112d) of the second type configured to detect infrared light.

13. The imaging device according to claim 11 or 12, wherein the at least one light detecting unit (112a-c; 212a-b; 312a-d) of the first type and the at least one light detecting unit (112d; 212c-d; 312e-f) of the second type in the image element units (114; 214; 314) are arranged displaced in relation to each other in a direction along the main surface (104) of the semiconductor substrate (102) such that the photo-sensitive areas (120) of the first type are configured to detect light that is spatially separate from light detected by the photo-sensitive areas (148) of the second type.

14. The imaging device according to any one of the preceding claims, wherein a size of the photo-sensitive area (148) of the second type is larger than a size of the photo-sensitive area (120) of the first type.

15. A method for imaging comprising:
detecting (202) light of a first wavelength range using light detecting units of a first type, wherein each light detecting unit of the first type comprises a photo-sensitive area of a first type formed in or at a main surface of a semiconductor substrate;
detecting (204) light of a second wavelength range using light detecting units of a second type, wherein each light detecting unit of the second type comprises a stacked layer structure formed on the main surface of the semiconductor substrate, wherein the stacked layer structure comprises an active layer, which forms a photo-sensitive area of a second type and is configured to generate charges in response to incident light, and wherein the stacked layer structure is configured to control transporting of charges generated by the active layer, wherein the light detecting units of the first type and light detecting units of the second type are arranged displaced in relation to each other in a direction along the main surface of the semiconductor substrate such that the photo-sensitive areas of the first type are configured to detect light that is spatially separate from light detected by the photo-sensitive areas of the second type; and
simultaneously reading out (206) signals representative of light incident on the light detecting units of the first type and light incident on the light detecting units of the second type.
